# EUROPEAN PATENT APPLICATION

(11) **EP 2 993 781 A1**
(43) Date of publication of application: **09.03.2016**
(21) Application number: 14791922.9
(22) Date of filing: 24.04.2014
(51) Int. Cl.: H02P 29/00, B60L 3/00

(54) **CONTROL DEVICE AND DRIVE DEVICE FOR MOTOR**

(30) Priority: 30.04.2013 JP 2013095442
(71) Applicant: Fuji Electric Co., Ltd., Kawasaki-shi, Kanagawa 210-9530 (JP)
(72) Inventor: TAKEI, Osamu, Kawasaki-shi Kanagawa 210-9530 (JP)
(74) Representative: Appelt, Christian W.
(86) International application number: PCT/JP2014/061605
(87) International publication number: WO 2014/178331

(57) **Abstract**

A control device is provided, which is capable of allowing a load factor to be understood easily while obviating reliably errors in selecting a rated value of an electric motor driven by a driving device without requiring any unnecessary labor in management of the rated value. The control device includes:
an acquiring unit that acquires via a communication line reference value data indicating predetermined reference values for a torque and a rotating speed, which are parameters indicating an operating state of an electric motor, from a driving device that controls driving of the electric motor; and a calculating unit that acquires via the communication line present value data indicating one of a physical quantity, which is a value of the respective parameters measured in the electric motor during operation and a ratio of the physical quantity to the reference value from the driving device, and calculates the other one of the physical quantity and the ratio from the present value data and the reference value data.

## Description

### TECHNICAL FIELD

The present invention relates to a technique of controlling a driving device that controls driving an electric motor by controlling power supplied to the electric motor.

### BACKGROUND ART

In recent years, electric vehicles are becoming more common rapidly. In an electric vehicle, an electric motor such as a three-phase AC motor is mounted as a power source. Moreover, a driving device such as an inverter that controls driving of the electric motor and a control device that communicates with the driving device to control the driving device are also mounted (for example, see Patent Document 1). The control device executes a process of adjusting various command values (for example, a value indicating a physical quantity of an output torque such as x[Nm]) such as a torque command supplied to the driving device according to an operation of a driver. The driving device executes a process of adjusting AC power supplied to the electric motor according to the command values. In this way, the traveling of an electric vehicle is controlled. Moreover, the control device also executes a process of acquiring various items of data (for example, data indicating present values of an output torque and a rotating speed (the number of revolutions per unit time)) stored in a memory of the driving device via a signal line and controlling the display of various meters based on these items of data. In this way, the driver can understand the vehicle state.

Patent Literature 1: Japanese Patent Application Publication No. 2013-038912

### DISCLOSURE OF THE INVENTION

As described above, various items of data are transmitted and received between the driving device and the control device via the signal line. Moreover, during maintenance inspection of the driving device, a testing apparatus such as a personal computer is connected to the driving device as the control device to conduct various tests such as observation of behavior of the electric motor when the data stored in the memory of the driving device is referred to or the data is updated.

During maintenance inspection of the driving device, it is often important to understand the percent (%) quantity (hereinafter a load factor) to a rated value of the output torque and the rotating speed of the electric motor. However, in many case, the data transmitted and received between the driving device and the control device is data indicating the physical quantity of respective parameters. Thus, it has not been possible to obtain the load factor directly from the driving device. Therefore, in the related art, a method in which the rated values of a plurality of types of electric motors which can be controlled by the driving device are stored in advance in the control device, a test operator selects a suitable rated value whenever maintenance inspection is performed, and the control device calculates a load factor based on the rated value is often used. However, this method has a problem in that management of the rated values in the control device incurs an unnecessary labor and errors in selecting the rated value may occur.

The present invention has been made in view of the above-described problem, and an object of the present invention is to provide a technique of allowing a load factor to be understood easily while obviating errors in selecting a rated value of an electric motor driven by a driving device reliably without requiring any unnecessary labor in management of the rated value is provided.

In order to solve the problem, the present invention provides a control device including the following acquiring unit and calculating unit as a control device that controls a driving device that controls driving of an electric motor. The acquiring unit acquires predetermined reference values for an output torque (hereinafter referred to simply as a "torque") of the electric motor, a rotating speed, a temperature (or a temperature of the driving device) of the electric motor, and a current or a voltage supplied to the electric motor from the driving device, which are parameters indicating an operating state of the electric motor from the driving device via a communication line. The calculating unit acquires data indicating one of a physical quantity which is a value of the respective parameters measured in the electric motor in operation and a ratio (for example, percent (%) quantity) of the physical quantity to the reference value from the driving device, and calculates the other one of the physical quantity and the ratio.

A specific example of the control device includes a testing apparatus used when performing maintenance inspection of the driving device and a vehicle control unit (VCU). In a more preferred aspect, the control device may further include a display control unit that controls display of the respective parameters on a display device based on at least one of the present value data acquired from the driving device and a calculation result obtained by the calculating unit. For example, when the present invention is applied to a testing apparatus, one (or both) of the physical quantities and the percent (%) quantities of the respective parameters can be displayed by the display device. When the percent (%) quantities are displayed, a test operator can figure out the load factor of the electric motor in operation quickly and at a glance. As a specific example of the reference value, the rated value of the electric motor or a value (for example, a maximum allowable value indicating the upper limit of an allowable range) indicating an allowable range such as an upper or lower limit may be used for the torque, the rotating speed, the current, and the voltage, and a maximum allowable value may be used for the temperature. According to the control device of the present invention, since the reference value data indicating the rated value or the like is acquired from the driving device, the management of the reference value such as the rated value does not incur any unnecessary labor and errors in selecting the reference value is obviated reliably.

In a more preferred aspect, when a maximum allowable value is used as the reference value, the display control unit may cause the display device to display a screen for displaying the respective parameters in a meter form and may determine the scale of the meter according to the maximum allowable value. According to such an aspect, a test operator can figure out how much allowance does the operating state of the electric motor has from the display content of the display device quickly and at a glance. Further, the display control unit may display the present value of at least one of the torque and the rotating speed of the parameters on the screen so as to be paired with a command value supplied to the driving device via the communication line. According to such an aspect, since the command values and the present values of the torque and the rotating speed are displayed in a meter form, both can be compared immediately. Moreover, in addition to the meter form, the present values of the respective parameters may naturally be displayed on the screen in numerical values of physical quantities and percent (%) quantities.

In a more preferred aspect, a mode switching unit that implements switching between two operation modes of a torque mode of designating a torque and a rotating speed mode of designating a rotating speed may be provided in the control device, and input regions in which command values for the torque and the rotating speed are input, respectively, are provided in the screen. Moreover, display control unit may display the present value of the rotating speed acquired from the driving device via the communication line in the input region for the rotating speed in the torque mode and may display the present value of the torque acquired from the driving device via the communication line in the input region for the torque in the rotating speed mode. According to such an aspect, it is possible to obviate a command value that is discontinuous from the present value from being supplied to the driving device according to switching of the operation mode.

In a still more preferred aspect, an input region in which a command value for a torque or a rotating speed is input may include a first input region in which a physical quantity is input and a second input region in which a percent (%) quantity is input as the command value. Moreover, the display control unit may execute a process of updating a display content of one of the first input region and the second input region according to a content input to the other one of the input regions. According to such an aspect, the command value for the torque or the rotating speed can be input in the form of a percent (%) quantity as well as the physical quantity.

In another preferred aspect, the calculating unit may execute a process of appending the command value to be supplied to the driving device with an identifier indicating whether the command value is a command value for the torque or the rotating speed and indicating whether the command value is a physical quantity or a percent (%) quantity, and providing the command value, to which the identifier has been appended, to the driving device. If the driving device receives the command value in a percent (%) quantity, it is possible to conceal the rated value, the maximum allowable value, and the like from the outside and to conceal any clues for analyzing a control program or the like of the driving device illegally.

In another preferred aspect, the control device may further include an operator that increases or decreases the command value for the torque or the rotating speed by a predetermined value (for example, +0.1 % or -0.1 % when the command value is given in a percent (%) quantity). According to such an aspect, the command value can be adjusted finely.

In order to solve the above-described problem, the present invention provides a driving device including a driving control unit that controls driving of an electric motor and a customizing unit that executes the following first and second processes as a driving device that controls driving of an electric motor. The driving control unit is a core unit that is appropriately customized according to a model or the like of the electric motor connected to the driving device. The first process is a process of supplying reference value data indicating predetermined reference values for a torque, a rotating speed, a temperature, a current, and a voltage which are parameters measured in an electric motor which is driven and controlled by the driving control unit to a control device via a communication line. The second process is a process of controlling the operation of the driving control unit according to a command value for the torque or the rotating speed supplied from the control device via the communication line, the second process involving converting the command value to a value indicating a ratio relative to the reference value and controlling the operation of the driving control unit according to a conversion result when a physical quantity is supplied as the command value. For example, when a command value, to which an identifier indicating whether the command value is a command value for the torque or the rotating speed and indicating whether the command value is a physical quantity or a ratio relative to the reference value is appended, is supplied from the control device via the communication line, the second process may cause the customizing unit to determine whether the command value is a value indicating the ratio by referring to the identifier.

### BRIEF DESCRIPTION OF THE DRAWINGS

Fig. 1 is a diagram illustrating a configuration example of a testing system 1 including a testing apparatus 10 which is an embodiment of a control device of the present invention.
Fig. 2 is a diagram illustrating a configuration example of the testing apparatus 10.
Fig. 3 is a diagram illustrating an example of a screen displayed on a display unit of a user I/F unit 120 of the testing apparatus 10.
Figs. 4A and 4B are diagrams illustrating examples of a format of a communication message transmitted from the testing apparatus 10 to a driving device 20.
Fig. 5 is a diagram illustrating a configuration example of the driving device 20.

### BEST MODE FOR CARRYING OUT THE INVENTION

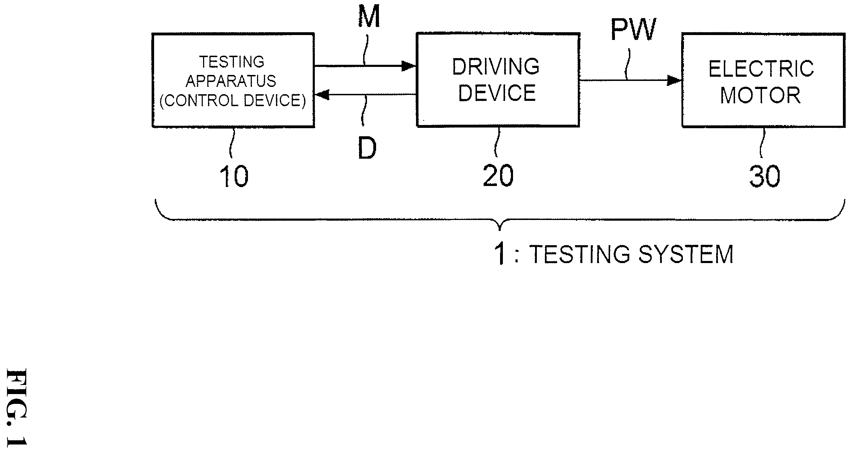

Hereinafter, an embodiment of the present invention will be described with reference to the drawings. Fig. 1 is a diagram illustrating a configuration example of a testing system 1 including a testing apparatus 10 which is an embodiment of a control device of the present invention. The testing system 1 is used for performing maintenance inspection of a driving device 20 mounted on an electric vehicle together with an electric motor 30. As illustrated in Fig. 1, the testing system 1 includes the driving device 20 that is subject to maintenance inspection, the electric motor 30 that is driven and controlled by the driving device 20, and the testing apparatus 10 that performs the role of a control device that controls the driving device 20 in the course of the maintenance inspection.

The driving device 20 is an inverter that converts DC power supplied from a DC power supply such as an in-vehicle battery to AC power PW and supplies the AC power PW to the electric motor 30. The driving device 20 includes a control unit (not illustrated) that executes a process of controlling the AC power PW supplied to the electric motor 30 according to various commands supplied from a control device (VCU in actual implementation or the testing apparatus 10 in the present embodiment) according to a control program installed therein in advance and a memory used as a work area during execution of the control program.

The memory of the driving device 20 stores measured values (physical quantities) of parameters indicating an operating state of the electric motor 30 such as an output torque of the electric motor 30, a rotating speed, a current and a voltage supplied from the driving device 20 to the electric motor 30, and a temperature of the electric motor 30 and data (hereinafter referred to as present value data) indicating a measured value of the temperature of the driving device 20 are stored. The memory further stores reference value data indicating predetermined reference values for the respective parameters, of an electric motor indicated by an electric motor identifier indicating a plurality of electric motors which can be connected to the driving device 20 in correlation with the electric motor identifier. As a specific example of the reference value, a rated value or a value indicating an allowable range (in the present embodiment, a maximum allowable value indicating the upper limit of an allowable range) such as an upper or lower limit may be used for the output torque and rotating speed of the electric motor and the current and voltage supplied to the electric motor. Moreover, a maximum allowable value may be used for the temperature of the electric motor and the temperature of the driving device 20. In the present embodiment, a maximum allowable value is used for all parameters as the reference value. The driving device 20 reads, from the memory, the reference value data stored in the memory in correlation with the electric motor identifier supplied from the testing apparatus 10 via a communication line and transmits the reference value data to the testing apparatus 10, and, moreover, the driving device 20 converts the physical quantities indicated by the present value data to percent (%) quantities (that is, values obtained by dividing the physical quantities by the reference values and multiplying by 100) indicating ratios to the reference values and transmits the percent (%) quantities to the testing apparatus 10. These operations of the driving device 20 exhibit one of the features of the present invention.

The testing apparatus 10 is a personal computer, for example, and is connected to the driving device 20 via a signal line such as a twisted-pair cable. In the present embodiment, the testing apparatus 10 supplies various commands M to the driving device 20 via the signal line to observe a change in the operation of the electric motor 30 and check the data D transmitted from the driving device 20. In this way, maintenance inspection of the driving device 20 progresses.

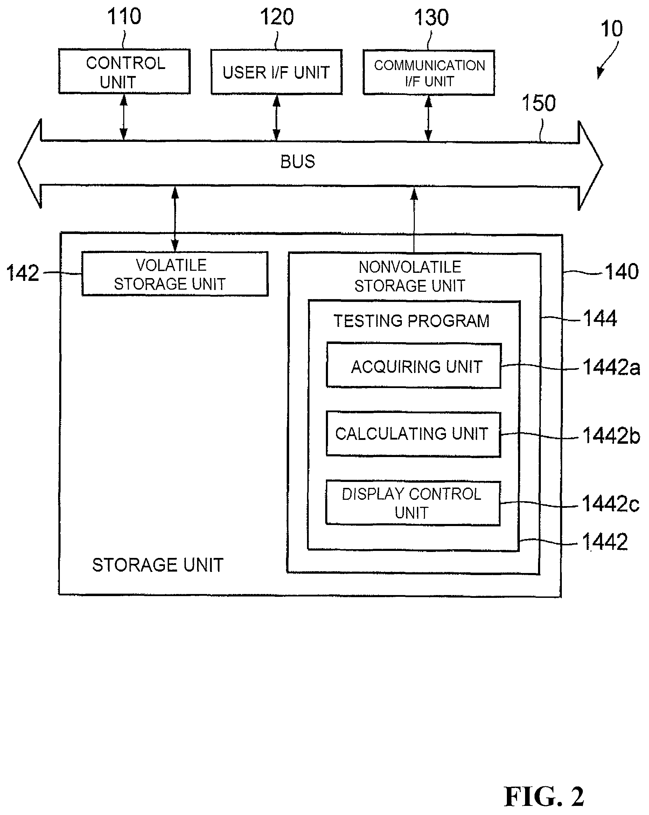

Fig. 2 is a diagram illustrating a configuration example of the testing apparatus 10. As illustrated in Fig. 2, the testing apparatus 10 includes a control unit 110, a user interface (hereinafter abbreviated as "I/F") unit 120, a communication I/F unit 130, a storage unit 140, and a bus 150 that relays exchange of data between these constituent elements.

The control unit 110 is a central processing unit (CPU), for example. The control unit 110 functions as a control center of the testing apparatus 10 by executing a testing program 1442 stored in the storage unit 140 (more specifically, a nonvolatile storage unit 144).

The user I/F unit 120 includes a display unit and an operating unit (both of which are not illustrated in Fig. 2). The display unit includes a liquid-crystal display and a driving circuit thereof. Various screens for maintenance inspection of the driving device 20 are displayed on the display unit under the control of the control unit 110. The operating unit includes a pointing device such as a mouse and a keyboard. The operating unit is used for allowing a test operator to input various operations for maintenance inspection of the driving device 20 and supplies data corresponding to the content of an operation performed on the pointing device or the like to the control unit 110. In this way, the content of the operations of the test operator is transmitted to the control unit 110.

The communication I/F unit 130 is a network interface card (NIC), for example, and is connected to the driving device 20 via a signal line such as a twisted-pair cable. The communication I/F unit 130 supplies the data received from the driving device 20 via the signal line to the control unit 110 and transmits the data supplied from the control unit 110 to the driving device 20 via the signal line.

The storage unit 140 includes a volatile storage unit 142 and a nonvolatile storage unit 144. The volatile storage unit 142 is configured as a random access memory (RAM), for example. The control unit 110 uses the volatile storage unit 142 as a work area when executing the testing program 1442. The nonvolatile storage unit 144 is configured as a hard disk or a flash memory, for example. The testing program 1442 is stored in advance in the nonvolatile storage unit 144. In addition to the testing program 1442, OS software that realizes an operating system (OS) is also stored in the nonvolatile storage unit 144. However, since the OS software has little relation with the present invention, the software is not depicted.

The control unit 110 reads the OS software from the nonvolatile storage unit 144 into the volatile storage unit 142 and starts executing the software when the power (not illustrated) of the testing apparatus 10 is turned on. In this state, when an instruction to execute the testing program 1442 is supplied via the operating unit of the user I/F unit 120, the control unit 110 reads the testing program 1442 from the nonvolatile storage unit 144 into the volatile storage unit 142 and starts executing the program. As illustrated in Fig. 2, the control unit 110 operating according to the testing program 1442 functions as an acquiring unit 1442a, a calculating unit 1442b, and a display control unit 1442c. The functions of these respective units will be described below.

The acquiring unit 1442a communicates with the driving device 20 via the communication I/F unit 130 and the signal line to acquire reference value data from the driving device 20. For example, the acquiring unit 1442a causes a screen for prompting an input of an electric motor identifier of the electric motor 30 driven by the driving device 20 to be displayed on the display unit of the user I/F unit 120 and supplies an electric motor identifier input by an operation on the operating unit of the user I/F unit 120 to the driving device 20 via the communication I/F unit 130 and the signal line. Moreover, the acquiring unit 1442a receives the reference value data transmitted from the driving device 20 via the communication I/F unit 130 and writes the reference value data in a predetermined storage area of the volatile storage unit 142. In this way, the reference value data is acquired.

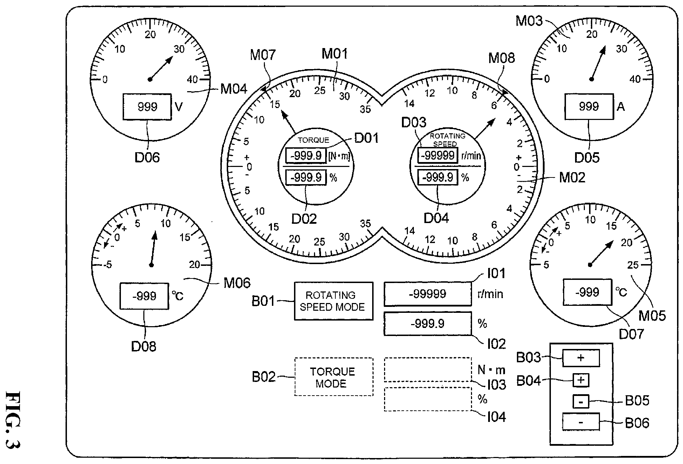

The calculating unit 1442b communicates with the driving device 20 via the communication I/F unit 130 and the signal line to acquire present value data. The calculating unit 1442b executes a process of multiplying the present value data acquired in the above-described manner by a reference value indicated by the reference value data and dividing the multiplication result by 100 for respective parameters to calculate physical quantities of the respective parameters. The display control unit 1442c controls the display of the respective parameters on the display unit of the user I/F unit 120 based on at least one of the present value data (that is, the percent (%) quantities of the respective parameters) acquired by the acquiring unit 1442a and the calculation result (that is, the physical quantities of the respective parameters) obtained by the calculating unit 1442b. Fig. 3 is a diagram illustrating an example of a screen that the display control unit 1442c displays on the display unit of the user I/F unit 120 in order to display the respective parameters. The display mode of the respective parameters on the screen exhibits the features of the present embodiment remarkably.

More specifically, as illustrated in Fig. 3, the display control unit 1442c displays the physical quantities of the respective parameters (the output torque of the electric motor 30, the rotating speed, the current supplied from the driving device 20 to the electric motor 30, the voltage applied to the electric motor 30, the temperature of the electric motor 30, and the temperature of the driving device 20) indicating the operating state of the electric motor 30 in an analog meter form. For example, in the screen illustrated in Fig. 3, the output torque of the electric motor 30 is displayed in an analog meter M01, the rotating speed is displayed in an analog meter M02, the current value of the current supplied to the electric motor 30 is displayed in an analog meter M03, the voltage applied to the electric motor 30 is displayed in an analog meter M04, the temperature of the electric motor 30 is displayed in an analog meter M05, and the temperature of the driving device 20 is displayed in an analog meter M06.

The display control unit 1442c sets the scales of the analog meters M01 to M06 according to the maximum allowable values of the respective parameters. Specifically, the display control unit 1442c determines the position of a needle according to a value obtained by dividing the physical quantity calculated by the calculating unit 1442b by the maximum allowable value so that the upper limit of the scale of each meter corresponds to the maximum allowable value. According to the present embodiment, as compared to a mode in which the respective physical quantities are displayed in numerical values, the test operator can figure out the magnitude of the physical quantity relative to the maximum allowable value quickly and at a glance from the position of the needle in the analog meter. In the present embodiment, all of the output torque of the electric motor 30, the rotating speed, the current flowing in the electric motor 30, the voltage applied to the electric motor 30, the temperature of the electric motor 30, and the temperature of the driving device 20 are displayed in the analog meter form. However, an arbitrary one or a plurality of parameters of these parameters may be displayed in the analog meter form and none of these parameters may be displayed in the analog meter form.

The display control unit 1442c displays at least one of the torque and the rotating speed among the respective parameters on the screen in the analog meter form so as to be paired with the command value supplied to the driving device 20 via the communication line. For example, in the example illustrated in Fig. 3, the command value of the torque is displayed in an analog meter M07, and the command value of the rotating speed is displayed in an analog meter M08. According to such an aspect, the test operator can figure out a difference between the command value and the present value quickly and at a glance based on a difference between the positions of the needles of the respective analog meters. In the present embodiment, although the present value and the command value of both the torque and the rotating speed are displayed in the meter form, the present value and the command value of any one of the torque and the rotating speed may be displayed in the meter form.

Moreover, the display control unit 1442c displays at least one of the physical quantity and the percent (%) quantity of each parameter in numerical values as well as in the analog meter form. For example, the physical quantity of the torque is displayed in a display region D01 and the percent (%) quantity of the torque is displayed in a display region D02. The physical quantity of the rotating speed is displayed in a display region D03 and the percent (%) quantity of the rotating speed is displayed in a display region D04. The physical quantity of the current is displayed in a display region D05, the physical quantity of the voltage is displayed in a display region D06, the physical quantity of the temperature of the electric motor 30 is displayed in a display region D07, and the physical quantity of the temperature of the driving device 20 is displayed in a display region D08. Thus, in the present embodiment, the test operator can understand the accurate present values of the respective parameters from the contents displayed in the display regions D01 to D08. The numerical values displayed in the display regions D01 to D08 in Fig. 3 indicate the maximum values (or the minimum values if the values are negative values) of the values that can be displayed in the respective regions.

As described above, although various inventive ideas have been made into a display mode of respective parameters in the screen illustrated in Fig. 3, another inventive idea is also made to improve the convenience of testing operations, which is another feature of the present embodiment. The testing apparatus 10 of the present embodiment has two operation modes of a torque mode and a rotating speed. The torque mode is an operation mode in which a torque is designated and the driving device 20 controls the driving of the electric motor 30. The rotating speed mode is an operation mode in which a rotating speed is designated and the driving device 20 controls the driving of the electric motor 30. Virtual operators B01 and B02 in Fig. 3 are virtual operators for allowing the test operator to switch the operation mode. When the testing apparatus 10 operates in the torque mode, the test operator can switch to the rotating speed mode by clicking on the virtual operator B01 using the mouse or the like included in the operating unit of the user I/F unit 120. When the testing apparatus 10 operates in the rotating speed mode, the test operator can switch to the torque mode by clicking on the virtual operator B02. That is, the operating unit of the user I/F unit 120 and the display unit that displays the virtual operators B1 and B2 serve as a mode switching unit for switching the operation mode.

In the screen illustrated in Fig. 3, input regions I01 and I02 are arranged in line with the virtual operator B01, and input regions I03 and I04 are arranged in line with the virtual operator B02. The input region I01 is an input region for allowing the test operator to input a command value for the rotating speed as a physical quantity in the rotating speed mode, and the input region I02 is an input region for allowing the test operator to input the command value as a percent (%) quantity in the rotating speed mode. The input region I03 is an input region for allowing the test operator to input a command value for the torque as a physical quantity in the torque mode, and the input region I04 is an input region for allowing the test operator to input the command value as a percent (%) quantity in the torque mode. Fig. 3 illustrates a case in which the testing apparatus operates in the rotating speed mode. The virtual operator B02 and the input regions I03 and I04 are depicted by dot lines in order to indicate that the testing apparatus operates in the rotating speed mode.

In the rotating speed mode, the command value for the rotating speed can be input to any one of the input regions I01 and I02. When the command value is input to one of the input regions I01 and I02, the display control unit 1442c updates the display content of the other one of the input regions according to the content input to one input region. For example, when a command value is input to the input region I01, the display control unit 1442c converts the command value to a percent (%) quantity and displays the percent (%) quantity in the input region I02. Conversely, when a command value is input to the input region I02, the display control unit 1442c converts the command value to a physical quantity and displays the physical quantity in the input region I01. Similarly, in the torque mode, the command value for the torque can be input to any one of the input regions I03 and I04. When a command value is input to one of the input regions I03 and I04, the display control unit 1442c updates the display content of the other one of the input regions according to the content input to one input region.

In the rotating speed mode, the display control unit 1442c inhibits any input to the input regions I03 and I04 and displays the physical quantity and the percent (%) quantity of the present value of the torque in the input regions I03 and I04, respectively. Similarly, in the torque mode, the display control unit 1442c inhibits any input to the input regions I01 and I02 and displays the physical quantity and the percent (%) quantity of the present value of the rotating speed in the input regions I01 and I02, respectively. Here, the present value is displayed in an input region to which any input is inhibited in the respective operation modes. This is to prevent a command value which deviates greatly from the present value from being given even when the operation mode is changed and the display content of an input region to which any input has been inhibited is given as the command value as it is. In the present embodiment, although the command value of the rotating speed and the torque can be input in the form of both a physical quantity and a percent (%) quantity, the command value may be input in the form of any one of the physical quantity and the percent (%) quantity. For example, when the command value is input in the form of the physical quantity only, the input regions I02 and I04 may be omitted. When the command value is input in the form of the percent (%) quantity only, the input regions I01 and I03 may be omitted.

Virtual operators B03 to B06 in Fig. 3 are virtual operators for allowing the test operator to increase and decrease the command value of the torque or the rotating speed by a predetermined value in the respective operation modes. Specifically, the virtual operator B03 is a virtual operator for allowing the test operator to change the command value by +1.0%. The virtual operator B04 is a virtual operator for allowing the test operator to change the command value by +0.1%. The virtual operator B05 is a virtual operator for allowing the test operator to change the command value by -0.1 %. The virtual operator B06 is a virtual operator for allowing the test operator to change the command value by -0.1 %. For example, by clicking on the virtual operator B03 continuously, the virtual operator can understand the change in an operating state of the electric motor 30 when the command value is increased from a certain value by 1.0%. In the present embodiment, an operator for allowing the test operator to increase and decrease the command value for the torque or the rotating speed by a predetermined value is realized by the virtual operator. However, the operator provided in the operating unit of the user I/F unit 120 may perform the functions of the virtual operators B03 to B06. Moreover, the operator for allowing the test operator to increase and decrease the command value for the torque or the rotating speed by a predetermined value is not essential and may naturally be omitted.

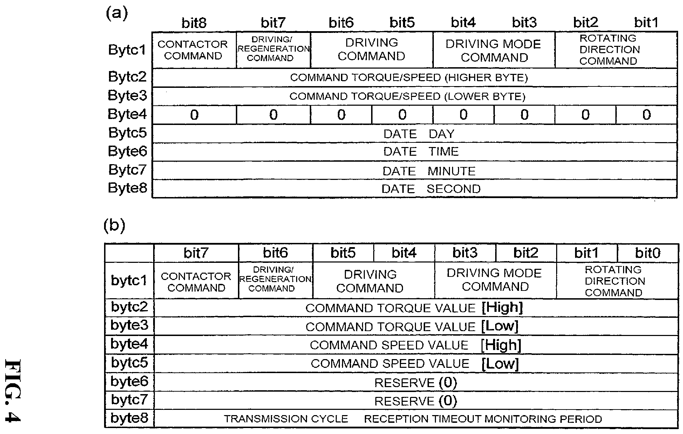

When the command value input by operations on the screen illustrated in Fig. 3 is supplied to the driving device 20, a predetermined one of the physical quantity or the percent (%) quantity may be supplied depending on the specification of the driving device 20. Alternatively, the command value may be supplied to the driving device 20 by appending an identifier to the command value, the identifier indicating whether the command value is a command value for the torque or the rotating speed and indicating whether the command value is a physical quantity or a percent (%) quantity. For example, a communication format conforming to MCM illustrated in Fig. 4A may be employed as a communication format of a communication message transmitted and received between the driving device 20 and the testing apparatus 10. In this case, the calculating unit 1442b may execute the following process. That is, when a command value in the form of a percent (%) quantity is supplied to the driving device 20 as the torque command value, "00" is set to a driving mode command. When a command value in the form of a physical quantity is supplied to the driving device 20 as the torque command value, "01" is set to a driving mode command. When a command value in the form of a physical quantity is supplied to the driving device 20 as the rotating speed command value, "10" is set to a driving mode command. When a command value in the form of a percent (%) quantity is supplied to the driving device 20 as the rotating speed command value, "11" is set to a driving mode command. In this example, a driving mode command which is 2-bit information serves as the identifier.

Here, it is to be noted that the meaning and content of the command value when the driving mode commands are "01" and "10" are not contradictory to those of the existing MCM communication format. In the existing MCM communication format, the driving mode commands "00" and "11" are non-defined invalid values, and the former driving mode command "00" is regarded as meaning "stop". Thus, malfunctions or the like do not occur even when the driving device 20 is compatible with the existing MCM communication format only and is configured to accept physical quantities only as the command values. According to the present embodiment, it is possible to exchange command values in the form of percent (%) quantities while ensuring compatibility with existing communication formats. Even when a communication format of an ubi board illustrated in Fig. 4B is employed as a communication format of a communication message transmitted and received between the driving device 20 and the testing apparatus 10, the driving mode command may serve as the identifier similarly.

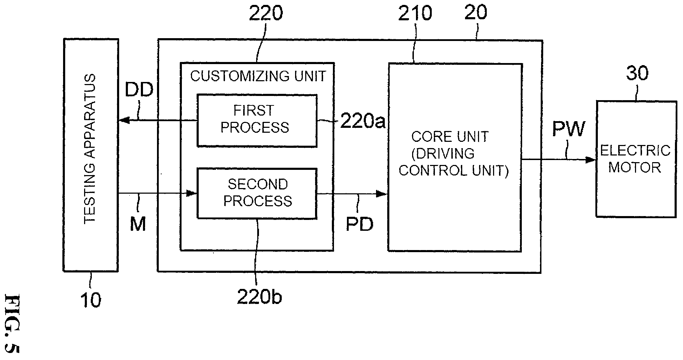

Fig. 5 illustrates an example of a configuration example of the driving device 20 that communicates with the testing apparatus 10 according to the communication format illustrated in Fig. 4A or 4B. As illustrated in Fig. 5, the driving device 20 includes a core unit 210 and a customizing unit 220. The core unit 210 and the customizing unit 220 are software modules realized when the control unit of the driving device 20 operates according to a control program. The functions of these software modules will be described below.

The core unit 210 is a driving control unit that controls the driving of the electric motor 30. The core unit 210 controls the AC power PW supplied to the electric motor 30 according to a command value (torque command or rotating speed command) PD supplied from the customizing unit 220. In the present embodiment, a command value indicating a percent (%) quantity is supplied from the customizing unit 220 as the command value PD. The core unit 210 is customized appropriately depending on the specification and the like of the electric motor 30 which is a drive control target.

The customizing unit 220 communicates with the testing apparatus 10 via the communication line and executes a first process 220a and a second process 220b illustrated in Fig. 5. The first process 220a is a process of transmitting reference value data DD for an electric motor which is driven and controlled by the core unit 210 to the testing apparatus 10 via the communication line. The second process 220b is a process of receiving a command value M for the communication format illustrated in Fig. 4A or 4B from the testing apparatus 10 via the communication line and controlling the operation of the core unit 210 according to the value of the driving mode command. More specifically, the customizing unit 220 determines whether the command value M is a physical quantity or a percent (%) quantity based on the value of the driving mode command. When the received command value is a physical quantity, the customizing unit 220 divides the command value M by the reference value indicated by the reference value data DD and multiplies a division result by 100 to convert the command value to a percent (%) quantity and supplies the conversion result to the core unit 210. When the received command value is a percent (%) quantity, the customizing unit 220 supplies the command value to the core unit 210. When the command value which always indicates a physical quantity is supplied from the testing apparatus 10 to the driving device 20, the customizing unit 220 may execute a process of converting the command value to a percent (%) quantity and supplying the conversion result to the core unit 210 as the second process 220b. In this case, the existing driving mode commands may be used as they are. Although not illustrated in detail in Fig. 5, the customizing unit 220 also executes a process of converting the physical quantities of the respective parameters to percent (%) quantities and transmitting the present value data D indicating the percent (%) quantities to the testing apparatus 10 via the communication line in addition to the first and second processes.

As described above, according to the present embodiment, the test operator can figure out the operating state of the electric motor 30 quickly and at a glance without requiring any unnecessary labor in management of the rated value of the electric motor 30 driven by the driving device 20. Moreover, the command values for controlling operations can be given in the form of a percent (%) quantity and a physical quantity, and the degree of freedom in giving the command values is improved as compared to the related art and the convenience can be improved. According to the present embodiment, since the testing apparatus 10 acquires the reference value data from the driving device 20, errors in selecting the reference values can be obviated reliably.

While an embodiment of the present invention has been described, the embodiment may naturally be modified in the following manner.
(1) In the above-described embodiment, although the parameters include a torque, a rotating speed, a temperature, a current, and a voltage, the parameters may include the torque and the rotating speed only.
(2) In the above-described embodiment, the driving device 20 executes the process of converting the physical quantities of respective parameters to the ratios to respective reference values and transmitting the present value data indicating the ratios to the testing apparatus 10 and the calculating unit 1442b of the testing apparatus 10 restores the physical quantities of the respective parameters based on the reference value data and the present value data acquired from the driving device 20. However, the driving device 20 may execute the process of transmitting the physical quantities of the respective parameters without converting the same and the calculating unit 1442b of the testing apparatus 10 may execute a process of calculating percent (%) quantities from the reference value data and the present value data acquired from the driving device 20. With such an aspect, the same advantageous effects as the above-described embodiment can be obtained.
(3) In the above-described embodiment, an application example in which the present invention is applied to a testing apparatus for performing maintenance inspection of the driving device 20 has been described. However, the present invention may naturally be applied to a testing apparatus for performing testing in the development stage of the driving device 20. Moreover, the present invention may be applied to a control device that communicates with the driving device 20 to control the operation thereof when the driving device 20 is operated actually. For example, when the electric motor 30 and the driving device 20 are mounted on an electric vehicle, the present invention may be applied to a vehicle control unit (VCU) that controls the operation of the driving device 20 according to an operation of the driver of the electric vehicle and controls the display of meters according to the present values of various parameters acquired from the driving device 20. Moreover, an application of the present invention is not limited to a control device that controls a driving device for electric vehicles, but the present invention may be applied to a control device that controls a driving device that drives an electric motor for raising and lowering an elevator and a driving device that drives an electric motor of an air conditioner.
(4) In the above-described embodiment, the testing program 1442 (that is, a program for causing the control unit 110 to function as the acquiring unit 1442a, the calculating unit 1442b, and the display control unit 1442c) for causing the control unit 110 to execute a process that exhibits the features of the present invention remarkably is stored in advance in a nonvolatile storage unit of the testing apparatus 10. However, the program may be distributed by recording the same on a computer-readable recording medium such as a compact disk-read only memory (CD-ROM) and may be distributed by downloading the same via a telecommunication line such as the Internet. When a control unit of an ordinary computer device such as a personal computer operates according to the program distributed in this manner, the computer device can function as the testing apparatus 10 of the above-described embodiment. The control program of the driving device 20 (that is, a program for causing the control unit of the driving device 20 to operate as the core unit (the driving control unit) 210 and the customizing unit 220) may be similarly distributed by recording the same on a computer-readable recording medium such as a CD-ROM and may be distributed by downloading the same via a telecommunication line such as the Internet.

### EXPLANATION OF REFERENCE NUMERALS

1: Testing system
10: Testing apparatus
110: Control unit
120: User I/F unit
130: Communication I/F unit
140: Storage unit
142: Volatile storage unit
144: Nonvolatile storage unit
1442: Testing program
1442a: Acquiring unit
1442b: Calculating unit
1442c: Display control unit
150: Bus
20: Driving device
210: Core unit
220: Customizing unit
30: Electric moto

## Claims

1. A control device comprising:
an acquiring unit that acquires via a communication line reference value data indicating predetermined reference values for a torque and a rotating speed, which are parameters indicating an operating state of an electric motor, from a driving device that controls driving of the electric motor; and
a calculating unit that acquires via the communication line present value data indicating one of a physical quantity, which is a value of the respective parameters measured in the electric motor during operation and a ratio of the physical quantity to the reference value from the driving device, and calculates the other one of the physical quantity and the ratio from the present value data and the reference value data.

2. The control device according to claim 1, wherein
the parameters include a temperature, a current, or a voltage.

3. The control device according to claim 2, further comprising:
a display control unit that controls display of the respective parameters on a display device, based on at least one of the present value data acquired from the driving device and a calculation result obtained by the calculating unit.

4. The control device according to claim 3, wherein
the reference values include maximum allowable values of the respective parameters, and the display control unit causes the display device to display a screen displaying physical quantities of the respective parameters in a meter form so that the maximum allowable values of the respective parameters correspond to an upper limit of a scale.

5. The control device according to claim 4, wherein
the display control unit displays at least one of the torque and the rotating speed of the respective parameters on the screen in the meter form so as to be paired with a command value supplied to the driving device via the communication line.

6. The control device according to claim 3, wherein
the display control unit displays a numerical value of at least one of the physical quantity of the respective parameters and the ratio of the physical quantity to the reference value on the screen.

7. The control device according to claim 4, wherein
the display control unit displays a numerical value of at least one of the physical quantity of the respective parameters and the ratio of the physical quantity to the reference value on the screen.

8. The control device according to claim 5, wherein
the display control unit displays a numerical value of at least one of the physical quantity of the respective parameters and the ratio of the physical quantity to the reference value on the screen.

9. The control device according to claim 3, further comprising:
a mode switching unit that implements switching between two operation modes of a torque mode of designating a torque and a rotating speed mode of designating a rotating speed, wherein
input regions, in which command values for the torque and the rotating speed are input respectively, are provided in the screen, and
the display control unit displays the present value of the rotating speed acquired from the driving device via the communication line in the input region for the rotating speed in the torque mode and displays the present value of the torque acquired from the driving device via the communication line in the input region for the torque in the rotating speed mode.

10. The control device according to claim 4, further comprising:
a mode switching unit that implements switching between two operation modes of a torque mode of designating a torque and a rotating speed mode of designating a rotating speed, wherein
input regions, in which command values for the torque and the rotating speed are input respectively, are provided in the screen, and
the display control unit displays the present value of the rotating speed acquired from the driving device via the communication line in the input region for the rotating speed in the torque mode and displays the present value of the torque acquired from the driving device via the communication line in the input region for the torque in the rotating speed mode.

11. The control device according to claim 5, further comprising:
a mode switching unit that implements switching between two operation modes of a torque mode of designating a torque and a rotating speed mode of designating a rotating speed, wherein
input regions, in which command values for the torque and the rotating speed are input respectively, are provided in the screen, and
the display control unit displays the present value of the rotating speed acquired from the driving device via the communication line in the input region for the rotating speed in the torque mode and displays the present value of the torque acquired from the driving device via the communication line in the input region for the torque in the rotating speed mode.

12. The control device according to claim 6, further comprising:
a mode switching unit that implements switching between two operation modes of a torque mode of designating a torque and a rotating speed mode of designating a rotating speed, wherein
input regions, in which command values for the torque and the rotating speed are input respectively, are provided in the screen, and
the display control unit displays the present value of the rotating speed acquired from the driving device via the communication line in the input region for the rotating speed in the torque mode and displays the present value of the torque acquired from the driving device via the communication line in the input region for the torque in the rotating speed mode.

13. The control device according to claim 7, further comprising:
a mode switching unit that implements switching between two operation modes of a torque mode of designating a torque and a rotating speed mode of designating a rotating speed, wherein
input regions, in which command values for the torque and the rotating speed are input respectively, are provided in the screen, and
the display control unit displays the present value of the rotating speed acquired from the driving device via the communication line in the input region for the rotating speed in the torque mode and displays the present value of the torque acquired from the driving device via the communication line in the input region for the torque in the rotating speed mode.

14. The control device according to claim 8, further comprising:
a mode switching unit that implements switching between two operation modes of a torque mode of designating a torque and a rotating speed mode of designating a rotating speed, wherein
input regions, in which command values for the torque and the rotating speed are input respectively, are provided in the screen, and
the display control unit displays the present value of the rotating speed acquired from the driving device via the communication line in the input region for the rotating speed in the torque mode and displays the present value of the torque acquired from the driving device via the communication line in the input region for the torque in the rotating speed mode.

15. The control device according to claim 9, wherein
an input region in which a command value for a torque or a rotating speed is input includes a first input region in which a physical quantity is input and a second input region in which the command value is input as a ratio relative to the reference value, and
the display control unit updates a display content of one of the first input region and the second input region according to a content input to the other one of the input regions.

16. The control device according to claim 10, wherein
an input region in which a command value for a torque or a rotating speed is input includes a first input region in which a physical quantity is input and a second input region in which the command value is input as a ratio relative to the reference value, and
the display control unit updates a display content of one of the first input region and the second input region according to a content input to the other one of the input regions.

17. The control device according to claim 11, wherein
an input region in which a command value for a torque or a rotating speed is input includes a first input region in which a physical quantity is input and a second input region in which the command value is input as a ratio relative to the reference value, and
the display control unit updates a display content of one of the first input region and the second input region according to a content input to the other one of the input regions.

18. The control device according to claim 12, wherein
an input region in which a command value for a torque or a rotating speed is input includes a first input region in which a physical quantity is input and a second input region in which the command value is input as a ratio relative to the reference value, and
the display control unit updates a display content of one of the first input region and the second input region according to a content input to the other one of the input regions.

19. The control device according to claim 13, wherein
an input region in which a command value for a torque or a rotating speed is input includes a first input region in which a physical quantity is input and a second input region in which the command value is input as a ratio relative to the reference value, and
the display control unit updates a display content of one of the first input region and the second input region according to a content input to the other one of the input regions.

20. The control device according to claim 14, wherein
an input region in which a command value for a torque or a rotating speed is input includes a first input region in which a physical quantity is input and a second input region in which the command value is input as a ratio relative to the reference value, and
the display control unit updates a display content of one of the first input region and the second input region according to a content input to the other one of the input regions.

21. The control device according to claim 1, further comprising:
an operator that increases or decreases the command value for the torque or the rotating speed by a predetermined value.

22. The control device according to claim 2, further comprising:
an operator that increases or decreases the command value for the torque or the rotating speed by a predetermined value.

23. The control device according to claim 9, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

24. The control device according to claim 10, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

25. The control device according to claim 11, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

26. The control device according to claim 12, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

27. The control device according to claim 13, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

28. The control device according to claim 14, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

29. The control device according to claim 15, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

30. The control device according to claim 16, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

31. The control device according to claim 17, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

32. The control device according to claim 18, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

33. The control device according to claim 19, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

34. The control device according to claim 20, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

35. The control device according to claim 21, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

36. The control device according to claim 22, wherein
the calculating unit appends the command value to be supplied to the driving device with an identifier indicating whether the command value is a command value for the torque or the rotating speed and indicating whether the command value is a physical quantity or a ratio relative to the reference value, and provides the command value, to which the identifier has been appended, to the driving device.

37. A driving device comprising:
a driving control unit that controls driving of an electric motor; and
a customizing unit that controls an operation of the driving control unit, wherein
the customizing unit executes:
a first process of supplying via a communication line reference value data indicating predetermined reference values for a torque, a rotating speed, a temperature, a current, and a voltage which are parameters measured in the electric motor, which is driven and controlled by the driving control unit, to a control device; and
a second process of controlling the operation of the driving control unit according to a command value for the torque or the rotating speed supplied from the control device via the communication line, the second process involving converting the command value to a value indicating a ratio relative to the reference value and controlling the operation of the driving control unit according to a conversion result when a physical quantity is supplied as the command value.

38. The driving device according to claim 37, wherein
the customizing unit receives a command value, to which an identifier indicating whether the command value is a command value for the torque or the rotating speed and indicating whether the command value is a physical quantity or a ratio relative to the reference value is appended, from the control device via the communication line, and in the second process, determines whether the command value is a value indicating the ratio by referring to the identifier.
